# FASCICULE DE BREVET EUROPEEN

(11) **EP 0 647 943 B1**
(45) Date de publication et mention de la délivrance du brevet: **04.10.2000**
(21) Numéro de dépôt: 94810446.8
(22) Date de dépôt: 28.07.1994
(51) Int. Cl.: G11C 5/00, G06K 19/077, E05B 49/00

(54) **Dispositif à mémoire**
Speicheranordnung
Memory device

(30) Priorité: 08.10.1993 CH 303293
(43) Date de publication de la demande: 12.04.1995
(73) Titulaire: VALTAC, Alex Beaud, 1228 Plan-les-Ouates (CH)
(72) Inventeur: Berney, Jean-Claude, CH-1343 Les Charbonnières (CH)
(74) Mandataire: Frei, Alexandra Sarah

(56) Documents cités:
- EP-A- 0 262 036
- WO-A-93/18485
- WO-A-93/24902
- FR-A- 2 546 327
- FR-A- 2 655 368
- GB-A- 2 082 804
- US-A- 4 660 172
- US-A- 4 945 217
- IBM TECHNICAL DISCLOSURE BULLETIN., vol.32, no.4B, Septembre 1989, NEW YORK US pages 109 - 110 'KEY WITH LCD INDICATOR'

## Description

La présente invention concerne un dispositif à mémoire électronique selon la revendication 1.

Il existe à l'heure actuelle de très nombreux dispositifs de petites dimensions, généralement sans source interne d'alimentation, qui utilisent des mémoires électroniques pouvant être lues, voir lues et écrites, par un système de lecture adéquat, et qui touchent à des applications qui nécessitent une sécurité particulière. On peut citer par exemple toutes les "cartes à puce" qui sont utilisées comme moyen de se procurer de l'argent (cartes de crédit, cartes bancaires, etc), les cartes à prépayement (téléphone, machines à café, parkings, etc), de même que les systèmes de clés électroniques plus ou moins sophistiqués.

Or deux points importants obèrent la fiabilité de la plupart de ces dispositifs, et limitent par là leurs applications. Premièrement ils sont montés sur des supports en matière plastique qui peuvent facilement se déformer, voire être détruits, lors de contraintes mécaniques ou thermiques même relativement courantes. Deuxièmement l'accès à la mémoire nécessite plusieurs contacts électriques, contacts qui sont une source importante et endémique de mauvais fonctionnements. Il est donc fréquent que le dispositif (carte, clé, etc) ne puisse plus être introduit dans l'appareil de lecture, ou ne puisse plus être lu par ce dernier.

Le document WO-93/24'902 montre une étiquette électronique miniature comportant une plaquette métallique sur laquelle est monté un circuit intégré. L'accès au circuit intégré est possible de manière coaxiale à travers une ouverture dans la plaquette métallique.

Les documents US-4'945'217 et WO-93/18'485 montrent des étiquettes électronique comportant un boîtier symétrique couvrant tout un sous-ensemble électronique et permettant un accès au circuit intégré en contactant les deux faces opposées du boîtier.

Le document EP-262'036 décrit un système de traitement d'information comportant plusieurs modules électroniques indépendants, chaque module est relié simultanément à un lecteur de cartes.

L'utilisation de ces dispositifs est donc limitée à des applications dans lesquelles leurs destructions éventuelles n'entraîneraient pas le cas échéant de conséquences trop fâcheuses.

Le document US-4'945'217 étant considéré comme décrivant l'état de la technique le plus proche et représente ainsi le préambule de la revendication principale.

L'invention a pour but d'apporter une solution à ces différents problèmes par un dispositif à mémoire électronique d'une construction particulièrement fiable.

Conformément à l'invention, ce but est atteint dans un dispositif à mémoire électronique selon la définition des revendications. Le dispositif comporte une partie en matière électro-conductrice servant à la fois de logement et de contact de sortie à un circuit intégré mémoire. La limitation au strict minimum du nombre de contacts ainsi que les caractéristiques mentionnées par la suite contribuent également à atteindre le but fixé. De préférence, ce dispositif comporte au moins un circuit intégré mémoire avec lecture ou lecture/écriture superposée à l'alimentation. Ce dispositif est agencé dans une partie métallique ou électro-conductrice rigide servant de logement dans lequel vient se fixer un support sur lequel sont montés le circuit intégré mémoire et au moins un contact de sortie. Ledit support ou interface d'interconnection comporte de préférence des zones métallisées agencées de manière à assurer, après assemblage, les liaisons entre la première borne d'alimentation du circuit intégré et le contact de sortie d'une part, et entre la deuxième borne d'alimentation du circuit intégré et ladite partie métallique d'autre part, cette partie métallique étant agencée pour assurer une liaison tant mécanique qu'électrique avec le système de lecture.

Cette construction permet donc de réaliser un dispositif miniaturisé robuste et dont l'accès ne présente aucune difficulté, vu que le dispositif n'a que deux contacts de sortie. Le dispositif selon l'invention peut, vu ses dimensions ultra-réduites, être incorporé dans un bon nombre d'objets sans se faire remarquer ou sans présenter d'inconvénients de par sa présence. Le dispositif peut contenir des informations qui se rapportent à l'objet dans lequel il est incorporé ou à la personne qui porte l'objet. Dans le premier cas ces informations peuvent donner des indications quant à la provenance ou l'appartenance de l'objet. Dans le second cas les informations peuvent donner des indications quant à l'identité ou l'état de la personne. Le dispositif est spécialement adapté à être incorporé dans une montre, un bracelet de montre, un bijou ou autre objet personnel.

L'invention est décrite ci-après à l'aide d'exemples et de références aux figures jointes, dans lesquelles:

La figure 1 représente un exemple de configuration interne d'un dispositif à mémoire selon l'invention.

La figure 2 représente schématiquement un dispositif selon l'invention utilisé comme pièce de monnaie électronique.

La figure 3 représente schématiquement un dispositif selon l'invention utilisé comme clé électronique.

La figure 4 représente schématiquement un dispositif selon l'invention utilisé comme carte de crédit multi-usages.

La figure 5 représente un dispositif selon l'invention incorporé à un bijou et utilisé pour stocker des renseignements, par exemple médicaux.

La figure 6 représente un dispositif selon l'invention incorporé à un fond de boîte de montre.

La figure 7 représente à titre d'exemple un dispositif selon l'invention incorporé à un couvercle de pile de montre.

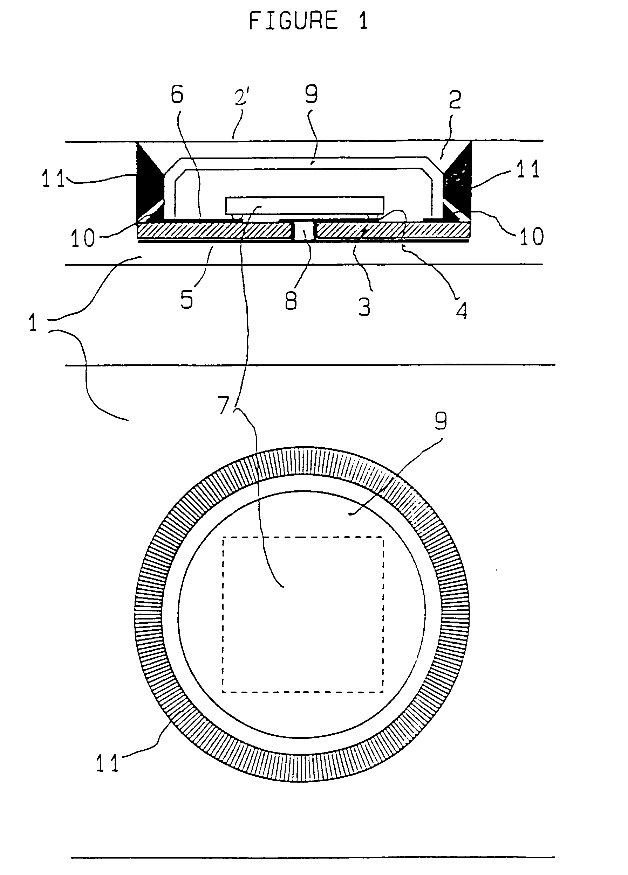

Sur la figure 1, composée d'une coupe (en haut) et d'une vue en plan (en bas), est représentée la partie 1 en matière électro-conductrice, donc par exemple métallique, qui comporte un logement 2. Dans ce logement se trouve un support 3. Ce support peut être un circuit imprimé comportant des zones métallisées 4, 5, 6 sur ses deux faces et sert donc d'interface d'interconnexion. Le circuit intégré mémoire 7 comporte des bornes ou "bumps" qui permettent d'assurer par thermocompression les liaisons entre le circuit intégré et les zones métallisées du support. Ces liaisons pourraient également être effectuées par bonding ou tout autre méthode connue. De même le support pourrait être réalisé sur céramique en technique Thin Film ou Thick Film, voire en matière plastique avec des contacts de forme surmoulés.

On connait à l'heure actuelle des circuits mémoire de type EEPROM qui peuvent être lus, voire lus et écrits, directement sur les bornes d'alimentation. Bien que ces circuits soient encore peu connus, nous n'entrerons pas en détail dans la description de leur fonctionnement, celui-ci faisant l'objet de demandes de brevet specifiques. Il suffit de savoir que ces circuits ne demandent que deux connexions électriques, un premier pôle d'alimentation relié à la masse, et le second pôle d'alimentation.

Sur la figure 1, le premier pôle d'alimentation du circuit intégré 7 est relié par la zone métallisée 4 à la zone métallisée 5 sur la face inférieure du support par l'intermédiaire du trou metallisé 8. Cette face inférieure du support est en contact avec la partie métallique 1. Ce contact pourra être assuré lors du montage soit par soudage, soit par une goutte de colle conductrice. Ainsi, la partie métallique est reliée électriquement au premier pôle d'alimentation du circuit intégré faisant office de masse.

Le second pôle d'alimentation du circuit intégré est placé dans le logement 2, accessible par une ouverture 2'et est relié à la zone métallisée 6 sur laquelle est fixé le contact métallique 9 par le cordon de soudure 10. Ce contact 9, évidé à l'intérieur, est placé par dessus le circuit intégré et sert donc de capot de protection à celui-ci. Enfin un joint par exemple en matière synthétique 11 est forcé entre le contact 9 et la paroi du logement de manière à assurer l'étanchéité du tout.

Dans cette configuration, le système de lecture pourra donc accéder aux deux bornes d'alimentation du circuit intégré EEPROM en établissant deux contacts, l'un avec la partie métallique de base 1, l'autre avec le contact 9.

Ainsi la partie métallique 1 joue à la fois un rôle électrique en servant de contact de masse, et un rôle mécanique en assurant la rigidité de l'assemblage du circuit intégré et de son contact. Cependant son rôle sur le plan mécanique ne se limite pas a cela, ce qui ressort des figures suivantes.

Notons que cette configuration très compacte permet d'utiliser le dispositif selon l'invention pour réaliser des exécutions très miniaturisées.

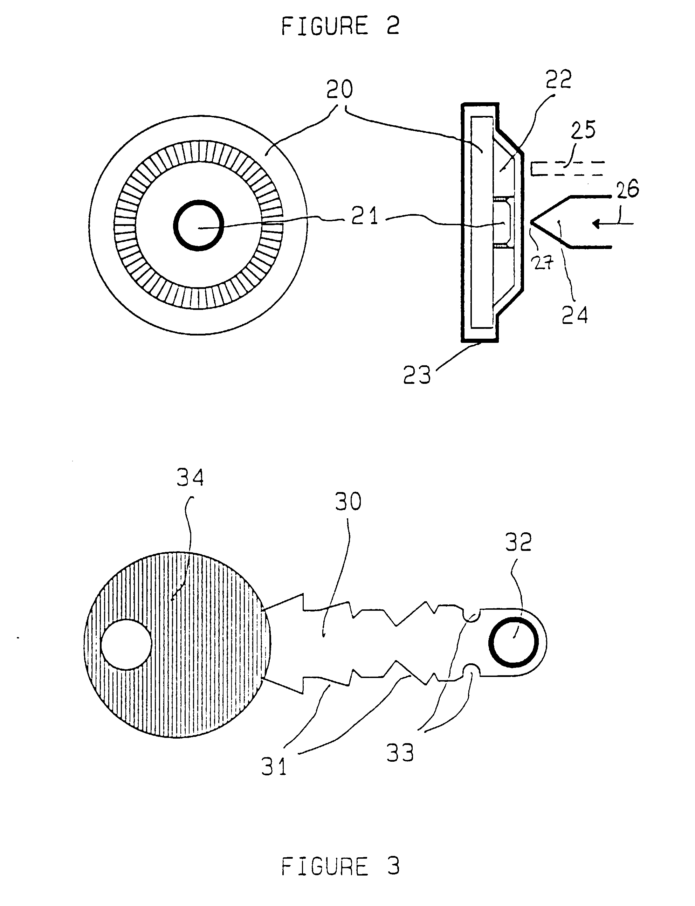

A la figure 2, qui comporte une vue en plan (à gauche) et une coupe (à droite), le dispositif selon l'invention est utilisé comme pièce de monnaie électronique. A cet effet la partie métallique 20 a une forme circulaire qui rappelle par son apparence et ses dimensions une pièce de monnaie avec en son centre le contact 21 permettant d'accéder au circuit intégré EEPROM qui contient les informations utiles pour cette application. Cependant la partie métallique n'a pas une épaisseur constante, mais présente une surépaisseur en son centre 22. Cette forme particulière de la partie mécanique a plusieurs utilités.

Premièrement une fonction de détrompage. En effet l'accès au système de lecture dans ce cas est une fente de forme 23 correspondant à la forme de la partie métallique du dispositif selon l'invention. Ainsi il n'est pas possible d'introduire une pièce plus grande. De même il est possible d'évacuer les pièces trop petites comme cela se fait dans les systèmes de tri des pièces de monnaie. Enfin il n'est pas possible d'introduire la pièce à l'envers.

Secondement une fonction de centrage. En effet, si le logement du système de lecture est suffisamment adapté à la forme de la pièce, le contact 22 est automatiquement centré par rapport à une pointe 27 du contact correspondant de un'appareil de lecture 24. Notons que le fait de n'avoir qu'un seul contact 27 facilite grandement ce positionnement puisque la position angulaire de la pièce dans le logement du système de lecture n'a pas d'importance. Il est également possible d'accéder à la partie métallique 20 d'un même côté par un second contact 25 faisant également partie de l'appareil de lecture 24 et pouvant approcher la pièce par un mouvement tel qu'il est indiqué par la flèche 26. Dans tous les cas, la fente est pourvue d'ouvertures permettant l'accès des contacts 24 et 25 appartenant à l'appareil 24.

Sur la figure 3, le dispositif selon l'invention est utilisé comme clé électronique. La pièce métallique 30 a la forme et les dimensions d'une clé normale et comporte sur ses deux flancs une découpe 31 qui lui permet d'actionner une serrure de type classique. Dans ce cas, ainsi que dans le cas présenté à l'aide de la figure 2, la partie métallique 20, 30, donc électro-conductrice, permet d'agir sur un système mécanique. Le circuit intégré avec son contact 32 est placé en bout de clé. Ainsi il est possible de combiner la fonction de clé mécanique classique avec la fonction de clé électronique. L'accès au système de lecture ne pourra se faire que si l'on arrive à actionner préalablement la fonction mécanique. Comme la forme de la pièce métallique est plus complexe que sur la figure 2, celle-ci comporte deux encoches 33 qui permettent de positionner le contact 32 avec précision par rapport au contact de l'appareil de lecture. Ainsi la partie métallique peut comporter des éléments servant particulièrement au positionnement du contact. Ces éléments peuvent être disposés sur l'extérieur ou à l'intérieur de la pièce métallique comme par exemple des trous de positionnement.

Notons enfin qu'il n'est pas nécessaire que la totalité de la clé soit métallique ou électro-conductrice, la pièce métallique pouvant se limiter à la zone utile où le circuit intégré est monté et où il est nécessaire d'avoir des points de repère précis pour le système de lecture. Ainsi la tête de la clé 34 peut-elle être réalisée en matière synthétique.

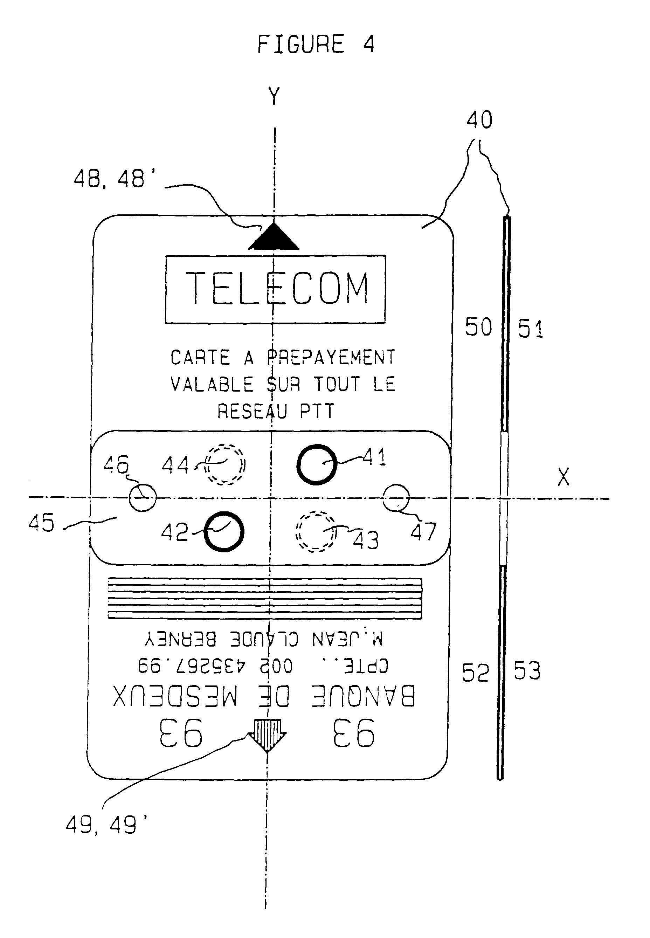

Sur la figure 4, le dispositif selon l'invention est utilisé dans une carte de crédit ou de prépayement. On assiste actuellement à une prolifération de ces cartes qui commencent à prendre une place importante dans maints portefeuille. Or on sait que ces cartes ont des dimensions normalisées bien précises qui empêchent toute miniaturisation à grande échelle. En raison des très petites dimensions du dispositif selon l'invention, il est possible de trouver une autre solution en réalisant des cartes multipuces qui permettraient en fait d'avoir sur un même support l'équivalent de plusieurs cartes normales. Ainsi sur la figure 4 est representée une carte 40 de dimensions normalisées (echelle environ 2) vue en plan (à gauche) et en coupe (à droite). On peut constater qu'une telle carte comporte deux axes de symétrie x et y et peut être introduite de 4 manières différentes dans un système de lecture (2 rotations de 180° sur l'axe X et 2 rotations de 180° sur l'axe Y). On peut donc placer 4 circuits intégrés montés avec leurs contacts 41, 42, 43, 44 sur leurs supports dans 4 logements distincts de la partie métallique 45. Ces 4 logements sont répartis de manière symétrique par rapport aux axes X et Y, soit deux dessus et deux dessous. La partie métallique comporte également deux trous 46 et 47 permettant d'indexer la carte dans le système de lecture.
La partie métallique 45 sert de contact (de masse) à tous les dispositifs qui y sont réunis.

Ainsi la carte comporte un dispositif permettant 4 fonctions indépendantes et peut être utilisée comme 4 cartes traditionnelles distinctes.

Notons que la portion utile de la partie métallique 45 portant les circuits intégrés est groupée au centre de la carte dans la zone la mieux protégée de celle-ci. Les parties extérieures (48, 49 et 48', 49' se trouvant au verso) peuvent être utilisées pour porter des indications relatives à chaque utilisation correspondante de la carte. Ces indications peuvent être fixes, ou être placées sur des étiquettes séparées 50, 51, 52, 53, par exemple des étiquettes métalliques autocollantes, ce qui permet de les changer si nécessaire.

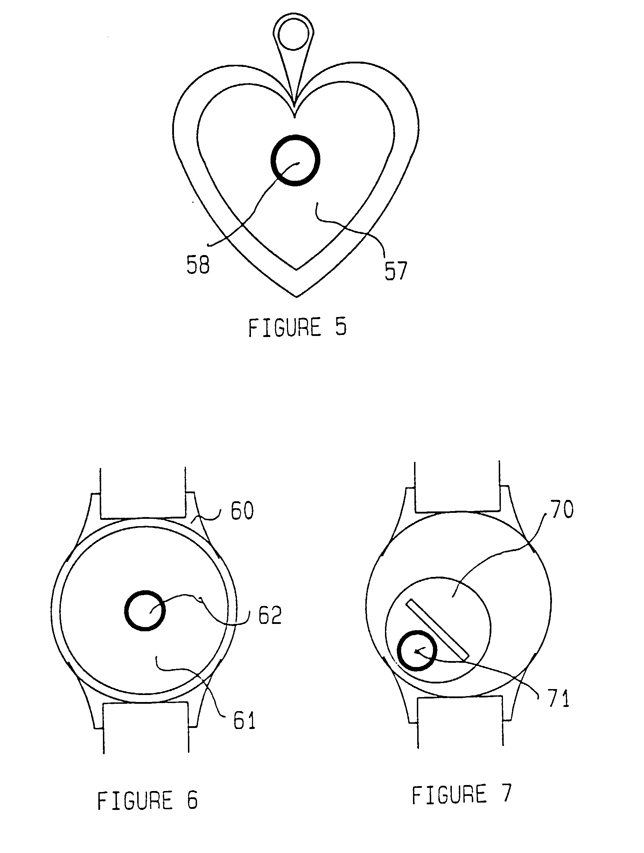

Les figures 5, 6 et 7 concernent une autre forme d'application du dispositif selon l'invention pour stocker des renseignements par exemple médicaux. Il existe de nombreux systèmes pour stocker des renseignements médicaux concernant une personne, groupe sanguin, allergies, traitements, etc, renseignements qui peuvent être lus rapidement si la personne doit être traitée, suite à un accident par exemple. Cependant ces systèmes sont souvent peu fiables. Par ailleurs, pour que le système soit efficace, il est nécessaire que la personne porte ces renseignements sur elle pratiquement en permanence, ce qui représente une contrainte non négligeable, surtout pour des enfants et les personnes du troisième âge. En raison de la miniaturisation extrême que permet le dispositif selon l'invention, il est possible de l'incorporer à de petits objets qui peuvent facilement être portés sur soi, ce qui permet de résoudre ce problème de manière simple.

La figure 5 représente schématiquement à titre d'exemple un bijou, par exemple un pendentif ou un bracelet, qui comporte une partie métallique 57, pouvant être en or ou en un autre métal précieux, partie métallique ou électro-conductrice sur laquelle est montée le support avec son circuit intégré mémoire et son contact 58. La face représentée est la face non visible du bijou, placée normalement contre la peau. Il est ainsi facile d'incorporer de manière très discrète le dispositif selon l'invention contenant dans sa mémoire les informations médicales utiles dans un bijou attractif pouvant être porté pratiquement en permanence.

La figure 6 représente à titre d'exemple un dispositif selon l'invention incorporé à une montre 60. Cette montre 60 comporte un fond métallique 61, sur lequel est monté le support avec son circuit intégré et son contact 62.

La figure 7 représente à titre d'exemple un dispositif selon l'invention incorporé à une montre en matière plastique. La majorité de ces montres sont du type à quartz avec alimentation par une batterie incorporée. Une grande partie de ces montres comportent sur leur fond un couvercle de pile métallique 70 permettant de changer la batterie sans ouvrir la montre. Il est donc possible d'utiliser ce couvercle comme partie métallique dans laquelle est monté le support avec son circuit intégré et son contact 71.

Il existe bien sur bien d'autres formes d'exécution du dispositif selon l'invention, mais leur description n'apporterait pas d'éléments supplémentaires à la compréhension de cette dernière.

## Revendications

1. Dispositif à mémoire électronique, comportant un circuit intégré (7) agencé sur un support (3) en matière électro-non-conductrice, comportant une partie de base (1) et un couvercle (9) tous les deux en matière électro-conductrice et servant de contacts de sortie pour le circuit intégré (7), la partie de base (1) et le couvercle (9) étant isolés électriquement l'un de l'autre, **caractérisée par le fait que** le circuit intégré (7) et le couvercle (9) sont agencés sur une première face du support (3), le support (3) comporte une zone métallisée (6) sur la première face reliant électriquement des bornes du circuit mémoire (7) au couvercle (9), le couvercle (9) servant de premier contact de sortie, le support (3) est logé dans la partie de base (1) à travers une zone métallisé (5) sur une deuxième face du support (3) et la zone métallisée (5) sur la deuxième face du support (3) reliant électriquement des bornes du circuit mémoire (7) à la partie de base (1), la partie de base (1) servant de second contact de sortie.

2. Dispositif selon la revendication 1, **caractérisé par le fait que** le couvercle (9) est accessible par une ouverture (2') de la partie de base (1) et que la partie de base (1) et le couvercle (9) constituent un boîtier de protection rigide pour le circuit intégré (7).

3. Dispositif selon la revendication 1 ou 2, **caractérisé par le fait que** les contacts (1, 9) de sortie servent à l'écriture/lecture et à l'alimentation du circuit intégré (7) et que la partie de base (1) est agencée pour assurer une liaison tant mécanique qu'électrique avec un système de lecture (24).

4. Dispositif selon une des revendications 1 à 3, **caractérisé par** un interface d'interconnexion comprenant le support (3) et des zones métallisées (4, 5, 6) sur ses deux faces reliant des bornes du circuit intégré (7) aux contacts de sortie.

5. Dispositif selon la revendication 2, **caractérisé en ce que** le boîtier de protection est constitué d'une part par la partie de base (1) formant un premier contact accessible à un appareil (24) de lecture/écriture et d'alimentation et est constitué d'autre part par le couvercle (9) formant un second contact accessible à l'appareil (24) et couvrant le circuit intégré (7).

6. Dispositif selon la revendication 1, **caractérisé par** une partie de base (1) en matière électro-conductrice ayant une forme (23, 31) permettant d'agir sur un système mécanique.

7. Dispositif selon la revendication 6, caractérisé par une forme (23) extérieure permettant de centrer les contacts de sorties par rapport à un appareil (24) de lecture.

8. Dispositif selon la revendication 1, **caractérisé en ce que** la partie de base (1) en matière électro-conductrice comporte plusieurs circuits intégrés (41, 42) et sert de contact pour plusieurs circuits intégrés.

9. Dispositif selon la revendication 6, **caractérisé par** une partie de base (1) en matière électro-conductrice ayant la forme d'une clé permettant d'agir sur une serrure.

10. Dispositif selon la revendication 6, servant de monnaie électronique.

11. Dispositif selon l'une des revendications 1 à 8, **caractérisé par** une partie de base (1) en matière électro-conductrice faisant partie d'un bijou.

12. Dispositif selon l'une des revendications 1 à 8, **caractérisé par** une partie de base (1) en matière électro-conductrice faisant partie d'une montre.

13. Dispositif selon l'une des revendications 1 à 8, **caractérisé par** une partie de base (1) en matière électro-conductrice faisant partie d'un objet porté sur une personne.

14. Dispositif selon l'une des revendications 1 à 8, **caractérisé par** une partie de base (1) en matière électro-conductrice faisant partie d'une carte de crédit.

15. Dispositif selon l'une des revendications 1 à 8, **caractérisé par** une partie de base (1) en matière électro-conductrice faisant office de couvercle de batterie.

16. Dispositif selon la revendication 8, **caractérisé par** une répartition symétrique des logements pour les circuits intégrés (41, 42, 43, 44) par rapport à deux axes de symétrie (X, Y).

## Patentansprüche

1. Elektronische Speichervorrichtung, bestehend aus einer integrierten Schaltung (7) angebracht auf einer Unterlage (3) aus einem elektrisch nichtleitenden Werkstoff, umfassend ein Grundteil (1) und einen Deckel (9), beide aus elektrisch leitendem Material hergestellt und als Kontakte für die integrierte Schaltung (7) dienend, wobei der Grundteil (1) und der Deckel (9) elektrisch voneinander isoliert sind, **dadurch gekennzeichnet, dass** die integrierte Schaltung (7) und der Deckel (9) auf einer ersten Seite der Unterlage (3) angebracht sind, die Unterlage (3) einen metallisierten Bereich auf der ersten Seite aufweist, welcher die Anschlüsse der integrierten Schaltung (7) mit dem Deckel (9) elektrisch verbindet, der Deckel (9) als erster Ausgangskontakt dient, die Unterlage (3) im Grundteil (1) über einen metallisierten Bereich (5) auf einer zweiten Seite der Unterlage (3) untergebracht ist, und der metallisierte Bereich (5) auf der zweiten Seite der Unterlage (3) die Anschlüsse der integrierten Speicherschaltung (7) elektrisch mit dem Grundteil (1) verbindet, wobei der Grundteil (1) als zweiter Ausgangskontakt dient.

2. Vorrichtung gemäss Patentanspruch 1, **dadurch gekennzeichnet, dass** der Deckel (9) durch eine Oeffnung (2') vom Grundteil (1) aus zugänglich ist und dass der Grundteil (1) und der Deckel (9) ein festes Schutzgehäuse für die integrierte Schaltung (7) bilden.

3. Vorrichtung gemäss Patentanspruch 1 oder 2, **dadurch gekennzeichnet, dass** die Ausgangskontakte (1, 9) zum Lesen / Beschreiben der und als elektrische Stromversorgung für die integrierte Schaltung (7) dienen und dass der Grundteil (1) so konstruiert ist, dass er sowohl eine mechanische wie auch eine elektrische Verbindung mit dem Lesesystem (24) gewährleistet.

4. Vorrichtung gemäss einem der Patentansprüche 1 bis 3, **gekennzeichnet durch** eine Verbindungsschnittstelle, welche aus der Unterlage (3) und den metallisierten Bereichen (4, 5, 6) besteht, die auf ihren beiden Seiten die Anschlüsse der integrierten Schaltung (7) mit den Ausgangskontakten verbindet.

5. Vorrichtung gemäss Patentanspruch 2, **dadurch gekennzeichnet, dass** das Schutzgehäuse einerseits aus dem Grundteil (1) besteht, der einen ersten für ein Gerät (24) zum Lesen/Beschreiben und für die Stromversorgung zugänglichen Kontakt bildet und andererseits aus dem Deckel (9) besteht, der einen zweiten für das Gerät (24) zugänglichen Kontakt bildet und die integrierte Schaltung (7) überdeckt.

6. Vorrichtung gemäss Patentanspruch 1, **gekennzeichnet durch** ein Grundteil (1) hergestellt aus elektrisch leitendem Material und eine Form (23, 31) aufweisend, welche eine Einwirkung auf ein mechanisches System möglich macht.

7. Vorrichtung gemäss Patentanspruch 6, **gekennzeichnet durch** eine äussere Formgebung (23), welche eine Zentrierung der Ausgangskontake in bezug auf ein Lesegerät (24) ermöglicht.

8. Vorrichtung gemäss Patentanspruch 1, **dadurch gekennzeichnet, dass** der aus elektrisch leitfähigem Material bestehende Grundteil (1) mehrere integrierte Schaltungen (41, 42) umfasst und als Kontakt für mehrere integrierte Schaltungen dient.

9. Vorrichtung gemäss Patentanspruch 6, **gekennzeichnet durch** ein Grundteil (1) aus elektrisch leitfähigem Material in der Form eines Schlüssels, welcher die Möglichkeit hat, auf ein Schloss zu wirken.

10. Vorrichtung gemäss Patentanspruch 6, zur Verwendung als elektronisches Geldstück.

11. Vorrichtung gemäss einem der Patentansprüche 1 bis 8, **gekennzeichnet durch** ein Grundteil (1) aus elektrisch leitfähigem Material, welcher ein Teil eines Schmuckstücks bildet.

12. Vorrichtung gemäss einem der Patentansprüche 1 bis 8, **gekennzeichnet durch** ein Grundteil (1) aus elektrisch leitfähigem Material, welcher ein Teil einer Armbanduhr bildet.

13. Vorrichtung gemäss einem der Patentansprüche 1 bis 8, **gekennzeichnet durch** ein Grundteil (1) aus elektrisch leitfähigem Material, welcher ein Teil eines auf einer Person getragenen Gegenstandes bildet.

14. Vorrichtung gemäss einem der Patentansprüche 1 bis 8, **gekennzeichnet durch** ein Grundteil (1) aus elektrisch leitfähigem Material, welcher ein Teil einer Kreditkarte bildet.

15. Vorrichtung gemäss einem der Patentansprüche 1 bis 8, **gekennzeichnet durch** ein Grundteil (1) aus elektrisch leitfähigem Material, welcher als Dekkel eines Batteriefachs dient.

16. Vorrichtung gemäss Patentanspruch 8, **gekennzeichnet durch** eine bezüglich zweier Symmetrieachsen (X, Y) symmetrische Anordnung von Gehäusen für die integrierten Schaltungen (41, 42, 43, 44).

## Claims

1. Electronic memory device, comprising an integrated circuit (7) located on a support (3) made of an electrically non-conductive material, comprising a base part (1) and a cover (9), both made of electrically conductive material and serving as output contacts for the integrated circuit (7), whereby the base part (1) and the cover (9) are electrically insulated from one another, **characterized in that** the integrated circuit (7) and the cover (9) are mounted on a first face of the support (3), the support (3) having a metallized zone (6) on the first face, which electrically connects the terminals of the integrated memory circuit (7) to the cover (9), the cover (9) serving as first output contact, the support (3) is accommodated in the base part (1) across a metallized zone (5) on a second face of the support (3), and the metallized zone (5) on the second face of the support (3) electrically connecting the terminals of the integrated memory circuit (7) to the base part (1), whereby the base part (1) serves as second output contact.

2. Device in accordance with claim 1, **characterized in that** the cover (9) is accessible through an aperture (2') from the base part (1) and that the base part (1) and the cover (9) constitute a rigid protection casing for the integrated circuit (7).

3. Device in accordance with claim 1 or 2, **characterized in that** the output contacts (1, 9) serve for reading / writing to and as electric power supply for the integrated circuit (7) and that the base part (1) is constructed to ensure both a mechanical and electrical connection with a reading system (24).

4. Device in accordance with one of the claims 1 to 3, **characterized by** an interconnection interface consisting of the support (3) and the metallized zones (4, 5, 6), which on both its faces connects the terminals of the integrated circuit (7) with the output contacts.

5. Device in accordance with claim 2, **characterized in that** the protection casing is constituted on the one hand by the base part (1) forming a first contact accessible to a device (24) for reading/writing to and serving as electric power supply and is constituted on the other hand by the cover (9) forming a second contact accessible to the device (24) and covering the integrated circuit (7).

6. Device in accordance with claim 1, **characterized by** a base part (1) made of electrically conductive material having a shape (23, 31) making it possible to act on a mechanical system.

7. Device in accordance with claim 6, **characterized by** an external shape (23) permitting to centre the output contacts relative to a reading device (24).

8. Device in accordance with claim 1, **characterized in that** the base part (1) made of electrically conductive material comprises several integrated circuits (41, 42) and serves as contact for several integrated circuits.

9. Device in accordance with claim 6, **characterized by** a base part (1) made of electrically conductive material having the shape of a key, making it possible for it to act on a lock.

10. Device in accordance with claim 6, serving as an electronic coin.

11. Device in accordance with one of the claims 1 to 8, **characterized by** a base part (1) made of electrically conductive material forming part of a piece of jewellery.

12. Device in accordance with one of the claims 1 to 8, **characterized by** a base part (1) made of electrically conductive material forming part of a watch.

13. Device in accordance with one of the claims 1 to 8, **characterized by** a base part (1) made of electrically conductive material forming part of an object carried on a person.

14. Device in accordance with one of the claims 1 to 8, **characterized by** a base part (1) made of electrically conductive material forming part of a credit card.

15. Device in accordance with one of the claims 1 to 8, **characterized by** a base part (1) made of electrically conductive material serving as a battery compartment cover.

16. Device in accordance with claim 8, **characterized by** a symmetrical arrangement of casings for the integrated circuits (41, 42, 43, 44) relative to two symmetry axes (X, Y).
